# EUROPÄISCHE PATENTANMELDUNG

(11) **EP 0 860 876 A2**
(43) Veröffentlichungstag der Anmeldung: **26.08.1998**
(21) Anmeldenummer: 98102800.4
(22) Anmeldetag: 18.02.1998
(51) Int. Cl.: H01L 23/482, H01L 21/60

(54) **Anordnung und Verfahren zur Herstellung von CSP-Gehäusen für elektrische Bauteile**

(30) Priorität: 21.02.1997 DE 19706811; 12.09.1997 DE 19740055
(71) Anmelder: DAIMLER-BENZ AKTIENGESELLSCHAFT, 70546 Stuttgart (DE)
(72) Erfinder: Kuisl, Max, Dr., 89079 Ulm (DE); Strohm, Karl, Dr., 89075 Ulm (DE); Rösler, Manfred, Dr., 89081 Ulm (DE)

(57) **Zusammenfassung**

Die Erfindung bezieht sich auf ein Gehäuse für elektrische Bauteile bei dem Anschlußpfosten innerhalb der Chipfläche realisiert werden, ohne daß zusätzliche Waferfläche über den Chiprand hinaus benötigt wird. Aus der direkten Durchführung der einzelnen elektrischen Anschlüsse resultiert eine geringe Zuleitungslänge und damit geringere parasitären Einflüsse, woraus sich optimale Bedingungen für den Einsatz bei höchsten Frequenzen ergeben.
Zudem bietet dieses Verfahren auch die Möglichkeit tiefe senkrechte Gräben am Chiprand auszubilden und so eine Trennätzung zur Vereinzelung durchzuführen, wobei eine Abdeckung der Seitenfläche mit Füllmaterial ohne weiteren Aufwand am Chiprand eine Passivierung bewirkt. Eine aufwendige Umverdrahtung der Anschlüsse auf der Chiprückseite ist durch geschicktes führen der Leiterbahnen von den Anschlußpfosten zum Bondpad nicht mehr notwendig.

## Beschreibung

Die Erfindung bezieht sich auf ein Gehäuse für elektrische Bauteile nach dem Oberbegriff des Patentanspruchs 1 und ein Verfahren zur dessen Herstellung nach dem Oberbegriff der Patentansprüche 8 und 9.

Mit zunehmender Hochintegration in der Informationstechnik werden die Anforderungen an die Aufbau- und Verbindungstechnik durch volumen- und gewichtssparende Bauformen immer anspruchsvoller. In vielen Anwendungsfällen wird der Einsatz von Elektronik erst durch den Aufbau von komplexen Systemen möglich die hochintegrierte elektrische Bauteile mit einer großen Anzahl externer Anschlüsse beinhalten. Übliche Systemträger sind nach wie vor Leiterplatten.
Seit etwa zwei Jahren wurde unter der Bezeichnung 'Chip Size Packaging' (nachfolgend als CSP bezeichnet) ein Häusungsverfahren von elektrischen Bauteilen entwickelt, bei dem der Platzbedarf des montierten Chips nicht größer als das 1.2-fache der Fläche des ungehäusten Bauteils ist (Crowley et al.: Workshop on Flip Chip and Ball Grid Arrays, Nov. 13-15, 1995, Berlin). Bei der Montage der gehäusten Bauteile auf Leiterplatten kommt hinzu, daß eine gute Verbindung auch bei kleinen Dimensionen gewährleistet sein muß. Das Verfahren ist sowohl für Einzelbauelemente, Integrierte Schaltungen (IC's) als auch für Hochfrequerzbauelemente einsetzbar.
Ein maßgebliches Kriterium bei der Herstellung ist, daß sich eine Vielzahl der auf großflächigen Substraten angeordneten Bauteile (im Waferverbund) mit den in der Halbleitertechnologie gängigen Verfahrensschritte bearbeiten lassen. Dies ist eine wichtige Voraussetzung für geringe Herstellungskosten bei hoher Ausbeute.

Es ist bekannt, daß eine Häusung nach dem Prinzip des CSP auf Waferebene angewandt wird. In den Patentschriften US 5,403,729 und US 5,441,898 sind solche Verfahren beschrieben. Sie bestehen aus einer Prozeßfolge bei der ein Integrierter Schaltkreis auf der Oberseite eines Halbleitermaterials mit einer Isolierschicht bedeckt wird und durch Öffnen von Kontaktlöchern elektrische Zuleitungen vom IC auf das Substratmaterial gelegt werden, die an den Enden vergrößerte Anschlußflächen besitzen. Das zwischen den Anschlußpunkten auf dem Substrat und dem IC liegende Substratmaterial wird durch eine Grabenätzung abgetragen. Die gesamte Oberfläche wird anschließend mit einer weiteren Isolierschicht, die auch den Graben ausfüllt, bedeckt. Um den auf der Vorderseite vorgegebenen Anschlußpunkt wird von der Rückseite eine weitere Ätzung vorgenommen, so daß aus dem Substratmaterial ein vom übrigen Gehäuse elektrisch getrennter und aus der Bauteilunterseite etwas herausragender Anschlußpfosten entsteht. Eine Metallschicht auf der Pfostenunterseite und Seitenfläche schließt den vorderseitigen Kontakt elektrisch an. Die Pfostenunterseite dient als Kontaktfläche beim Montieren des elektrischen Bauteils auf Leiterbahnen. Die nicht vorveröffentlichte Patentanmeldung AZ 197 06 811 beschreibt ein CSP-Herstellungsverfahren, das die Packungsdichte erhöht und dabei die Haftung des Anschlußpfostens auf einer Leiterbahn verbessert. Ebenfalls zu Stand der Technik gehört die 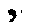 ball grid array 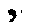 -Technik (BGA), bei der das gehäuste Bauteil die ursprüngliche Chipfläche nur noch gering übersteigt (Tomita, Y.: Studies of high pin count molded chip scale package, Area Array Packaging Technologies - Workshop on Flip Chip and Ball Grid Arrays). Die Besonderheit des BGA-Verfahrens steckt in der flächenhaften Anordnung der elektrischen Anschlüsse ihnerhalb der Chipfläche.
Ein großer Nachteil bei diesem Verfahren ist der zusätzliche Flächenbedarf für den Ritzrahmen, über den die elektrischen Kontakte geführt werden sowie die Beschränkung auf periphere Anschlüsse. Weiterhin können bei zunehmender Packungsdichte die Anschlußpfosten zu nahe an das Bauteil geraten, wobei dann das Lotmaterial einen Kurzschluß verursacht.
Weitere Nachteile ergeben sich durch die vergleichsweise langen, über den Chiprand geführten Leiterbahnen und den daraus bedingten parasitären Effekten, die sich besonders bei Hochfrequenzanwendungen nachteilig auswirken.

Der Erfindung liegt deshalb die Aufgabe zugrunde, ein Gehäuse für elektrische Bauteile und ein Verfahren zur dessen Herstellung anzugeben, beim Häusen von elektrischen Bauteilen die Packungsdichte zu erhöhen und kurze elektrische Zuleitungen zu realisieren und dabei die Haftung des Anschlußpfostens auf einer Leiterbahn zu verbessern.

Die Erfindung wird in Bezug auf das Gehäuse durch die Merkmale des Patentanspruchs 1 und in Bezug auf das Verfahren durch die Merkmale der Patentansprüche 8 und 9 wiedergegeben. Die weiteren Ansprüche enthalten vorteilhafte Aus- und Weiterbildungen der Erfindung.

Ein wesentlicher Vorteil der Erfindung besteht darin, daß Anschlußpfosten innerhalb der Chipfläche realisiert werden, ohne daß zusätzliche Waferfläche über den Chiprand hinaus benötigt wird. Aus der direkten Durchführung der einzelnen elektrischen Anschlüsse resultiert eine geringe Zuleitungslänge und damit geringere parasitären Einflüsse, woraus sich optimale Bedingungen für den Einsatz bei höchsten Frequenzen ergeben.
Besonders rationell ist, neben dem Einsatz von Standardprozessen der Halbleitertechnologie, daß alle Prozeßschritte im Waferverbund vorgenommen werden. Erst mit Hilfe der seit kurzer Zeit verfügbaren Technologie eines Hochratenätzprozesses lassen sich anisotrope, d.h. senkrecht verlaufende Ätzprofile in Substraten wie beispielsweise Silicium mit einer Tiefe herstellen, die außerdem die zur Strukturverkleinerung an Bauteilen erforderliche Präzision gewährleisten. Dabei können durch hohe Selektivitäten gegenüber Lack- und SiO₂-Masken steile Kanten bis zu einigen 100µm Tiefe erzeugt werden. Ergänzend bietet dieses Verfahren auch die Möglichkeit tiefe senkrechte Gräben am Chiprand auszubilden und so eine Trennätzung zur Vereinzelung durchzuführen, wobei eine Abdeckung der Seitenfläche mit Füllmaterial ohne weiteren Aufwand am Chiprand eine Passivierung bewirkt. Eine aufwendige Umverdrahtung der Anschlüsse auf der Chiprückseite ist durch geschicktes führen der Leiterbahnen von den Anschlußpfosten zum Bondpad nicht mehr notwendig.
Ein weiterer Vorteil besteht darin, daß für die Herstellung der Siliciumpfosten auf der Rückseite des Substrates ein Verfahren angewandt wird, durch das auf der ebenen Substratrückseite mit einer mehrlagigen Maskierung sowohl die Pfostengeometrie festgelegt wird und die Pfostenunterseite als Kontaktfläche zur verbesserten Haftung strukturiert wird.

Im folgenden wird die Erfindung anhand von vorteilhaften Ausführungsbeispielen unter Bezugnahme auf schematische Zeichnungen in den Figuren näher erläutert. Es zeigen:
- Fig. 1A/B: Prozeßfolge der Chipvorderseite;
- Fig.2A-F: Prozeßfolge mit mehrlagiger Maskierung der Chiprückseite zur Herstellung der Anschlußpfosten;
- Fig.3A/B: Chiprückseite mit direkter Durchführung der Anschlußpfosten;
- Fig.4: Chiprückseite mit über der Abdeckung erhabenen Anschlußpfosten;
- Fig.5A-C: Prozeßfolge als Variante zur Herstellung der Anschlüßpfosten;
- Fig.6A-E: Prozeßfolge mit zweilagiger Maskierung zur Herstelllung rückseitenstrukturierter Anschlußpfosten;
- Fig.7A-C: Prozeßfolge mit dreilagiger Maskierung zur Herstelllung rückseitenstrukturierter Anschlußpfosten;
- Fig.7D: Querschnitt eines gehäusten Bauteils, das auf eine Leiterbahn gelötet wurde.

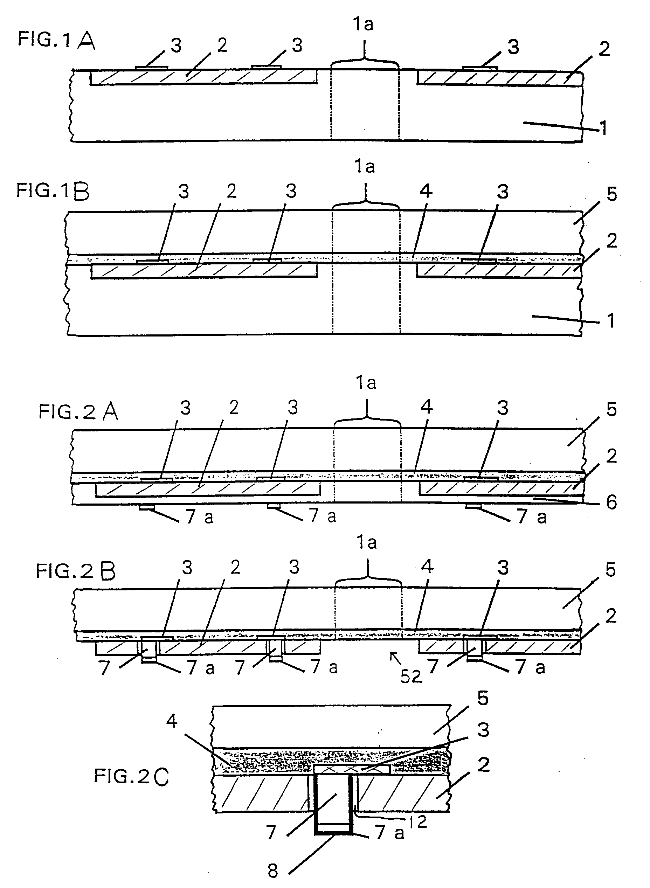

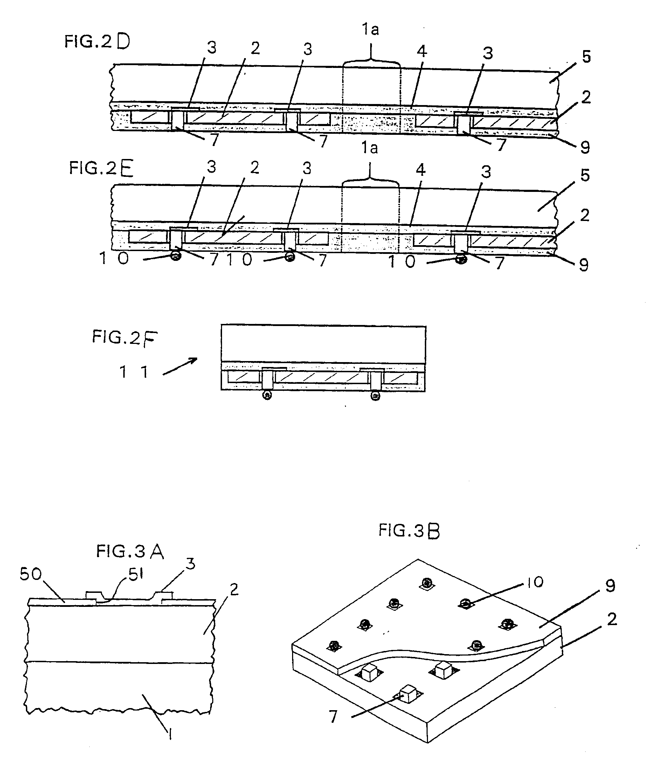

Im Ausführungsbeispiel, gemäß Figur 1, wird ein Halbleitersubstrat 1, vorzugsweise Silicium vorgegeben, auf dem sich eine Anzahl elektrischer Bauteile 2 (Chips) befinden (Fig.1A). Zwischen den Bauteilen 2 liegt ein Substratbereich frei, durch den der Sägeschnitt 1a zur späteren Trennung der Bauteile verläuft. Bestandteil der Oberfläche der Bauteile 2 ist eine elektrisch isolierende Deckschicht, beispielsweise Siliciumdioxid, die mit Kontaktlöchern für die elektrischen Anschlüsse versehen ist. Zur vereinfachten Darstellung ist die elektrisch isolierende Deckschicht 50 und die Kontaktlöcher 51 nur in Fig.3A detailliert dargestellt. Die Kontaktanschlüsse auf der Oberseite sind als Metalleiterbahnen 3 ausgeführt, die innerhalb der Chipfläche eine elektrische Verbindung mit den vorgesehenen Anschlußpfosten bewirken. Zum Abschluß der Vorderseitenstrukturierung wird die Oberfläche mit einer Vergußmasse 4, beispielsweise Epoxy, oder einem gut wärmeleitenden Kleber und einer Siliziumabdeckung 5 versehen (Fig.1B), wodurch die Chipoberfläche auf diese Weise vollständig passiviert ist.
Die Substratrückseite wird nun mechanisch oder chemisch bis auf etwa 100µm ganzflächig auf das Niveau gedünnt, das der späteren Pfostenunterseite entspricht (Fig.2A). Der Substratrest 6 der Rückseite ist nach diesem Schritt eben und damit für die nachfolgende Maskierung besonders gut vorbereitet. Auf der planaren Rückseite werden die Anschlußpfosten durch die folgenden Prozeßschritte herausgebildet und zugleich der Ritzrahmen, der etwas breiter als die Sägeschnittbreite 1a ausgebildet ist, zwischen den Bauteilen 2 zur späteren Vereinzelung der Chips freigelegt. In der Abbildung sind nur die wichtigsten Zwischenergebnisse dargestellt. Über eine erste Metallmaske 7a werden auf der Rückseite die Positionen für die Substratpfosten festgelegt, die aus dem Verlauf der Leiterbahnen auf der Vorderseite vorgegeben sind. Mit einer zweiten Maske (hier nicht dargestellt) wird die gesamte Unterseite bis auf den Substratbereich um die Pfosten und zwischen den Chips im Ritzrahmen 52 (Fig. 2B) abgedeckt. Anschließend wird durch einen Plasmaätzprozeß in einem Hochratenätzer mit hohem Aspektverhältnis das freiliegende Substratmaterial zwischen den Pfosten bis auf einen geringen Rest abgetragen. Nach Entfernen der zweiten Maske, wird das restliche Substratmaterial um die Pfosten und das Substratmaterial unter den Bauteilen abgeätzt. Die Ätzung wird abgebrochen, sobald im Ritzrahmen und um die Anschlußpfosten der Kleber 4 der Vorderseite erreicht ist. Der Ätzprozeß stoppt aber auch an einer Siliciumdioxid und an einer Metallgrenzfläche, d.h. auch an der Metallisierungsschicht, die innerhalb des Ätzspaltes 12 (Fig. 2C) freigelegt wird. Dies ist notwendig, um von der Chiprückseite die elektrischen Anschlüsse des Chips auf der Vorderseite zu kontaktieren. Damit entsteht eine etwas erhabene Pfostenstruktur 7 (Fig.2B), die vom restlichen Substrat elektrisch getrennt ist (Fig.2C). Durch Abtragen des Substrates innerhalb des Ritzrahmens werden die Chips voneinander getrennt und eine Vereinzelung vorbereitet. Der Zusammenhalt erfolgt nur noch durch die aufgeklebte Abdeckung auf der Waferoberseite. Die Metallisierung der Anschlußpfosten 7 erfolgt durch ganzflächiges Besputtern der Waferrückseite, Lackstukturieren und galvanisches Verstärken der vorgesehenen Leiterbahnzüge und Rückätzen der ganflächigen Metallisierungsschicht. Resultat ist eine elektrische Verbindung von den Bondpads der Chipvorderseite auf die Pfostenoberfläche der Rückseite. Die Substratpfosten sind nun auf der Vorderseite über die Kontaktinetallisierung oder den Bondpad mit dem IC elektrisch und über die Abdeckung 5 mechanisch verbunden. Um dem Pfosten Halt zu geben, wird der Ätzgraben und der Ritzrahmen mit Vergußmasse 9 ausgegossen, wobei auch die Rückseite des Chips mit Vergußmasse abgedeckt wird, so daß sich wiederum eine planare Oberfläche ergibt (Fig.2D). In diesem Stadium können bereits mit gängigen Verfahrensschritten Lotmaterial in Form von Bumps oder Ball Grids 10 aufgebracht werden (Fig.2E). Auf der planaren Oberfläche ist auch eine Umverdrahtung, sofern nötig, leicht durchführbar.
Sämtliche bisher beschriebenen Prozesschritte werden im Waferverbund vorgenommen. Die einzelnen Chips sind zwar durch die Trennätzung entlang des Ritzrahmens voneinander getrennt, werden aber durch dieAbdeckung auf der Vorderseite zusammengehalten. Das Vereinzeln der Chips 11 geschieht nun durch zersägen entlang der Trennspalte des Ritzrahmens (Fig.2F und Fig.3B). Dabei bleibt seitlich entlang der Trennspalte Vergußmasse erhalten, so daß der Chip allseitig geschützt bleibt.

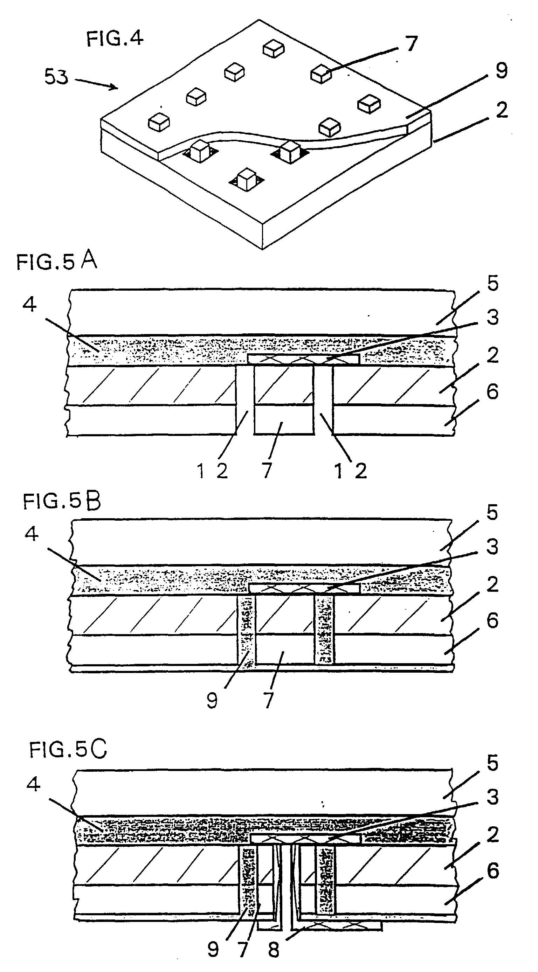

Im zweiten Beispiel wird der Verfahrensablauf gemäß Beispiel 1 zur Herstellung eines gehäusten Bauteils 53 laut Figur 4 in der Prozeßfolge variiert. Die Prozeßfolge wird durch einen weiteren Rückätzschritt der rückseitigen Abdeckung 9 ergänzt, wodurch die metallisierten Anschlußpfosten 7 aus der Oberfläche etwas heraustreten. Damit entsteht die Möglichkeit, die Geometrie der Pfosten so zu gestalten, daß sie auf die nachfolgenden Prozeßschritte beim Bonden der gehäusten Bauteile auf Leiterbahnen optimal angepaßt werden können.

Im dritten Beispiel wird die Strukturierung der Anschlußpfosten in der in Fig.5A bis C gezeigten Weise variiert. Ziel dabei ist, durch zwei aufeinanderfolgende Grabenätzungen die Metallisierung im Zentrum des Substratpfostens anzubringen, wobei zudem eine Isolierungsschicht die Substratrückseite von der Metallisierungsschicht elektrisch isoliert. Auf diese Weise kann auch auf der Rückseite eine Umverdrahtung der Anschlüsse vorgenommen werden. Die Variation der Prozeßfolge folgt auf den im Beispiel 1 beschriebenen Schritt der Dünnung der Substratrückseite bis auf den Rest 6. Im einzelnen wird mit Hilfe einer Maske eine Grabenätzung in den Bereichen 12 und dem Ritzrahmen durchgeführt (Fig. 5A). Die Gräben werden mit Epoxy 9 ausgefüllt, wobei das Material auch die gesamte Rückseite als Isolationsschicht überdeckt (Fig. 5B). Anschließend wird im Zentrum der Pfosten 7, wiederum über eine Maske, eine weitere Grabenätzung bis zum vorderseitigen elektrischen Kontaktpads vorgenommen und in einem weiteren Prozeßschritt der Graben durch eine Metallschicht 8 ausgekleidet, wobei die Metallschicht 8 zur Umverdrahtung auf der Rückseite verwendet werden kann, indem sie auf der Isolationsschicht weitergeführt wird (Fig. 5C). Durch einen letzten Schritt wird, wie schon in Beispiel 1 erläutert, eine Vereinzelung der Chips vorgenommen.

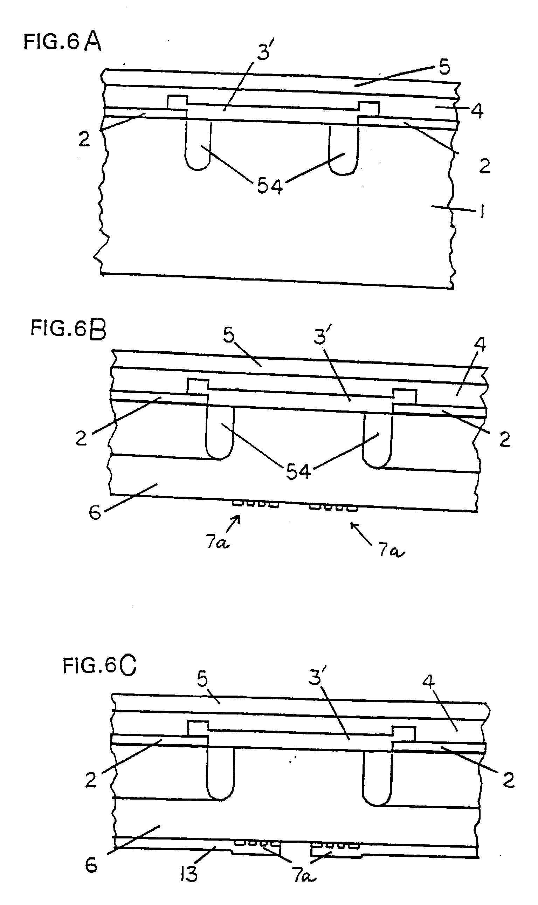

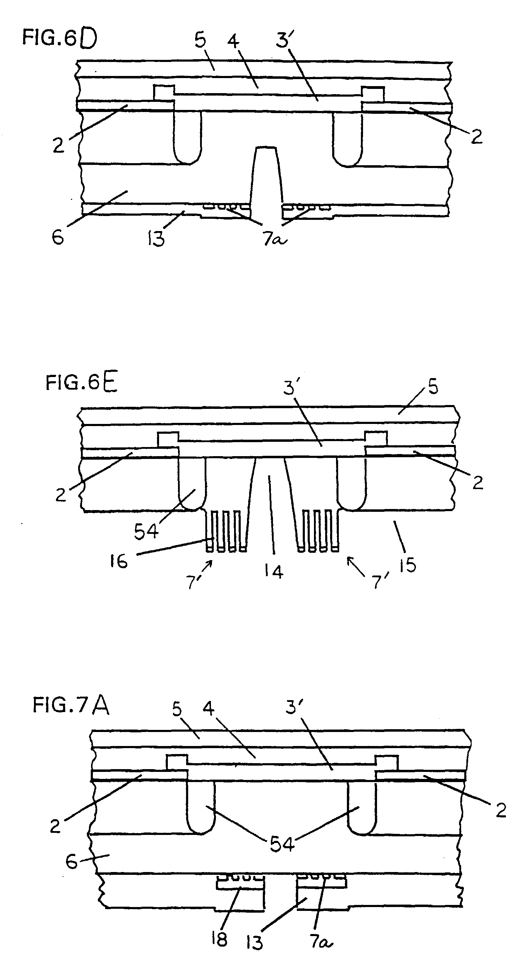

Im vierten Beispiel wird die Strukturierung von Anschlußpfosten zur besseren Haftung dargestellt (Fig.6A bis E). Die Bearbeitung der Vorderseite ist gegenüber den vorangehenden Beispielen etwas modifiziert, indem unmittelbar neben den elektrischen Bauteilen Grabenstrukturen 54 in das Substrat 1 geätzt werden und diese mit Epoxy gefüllt werden. Die Metalleiterbahn 3', die in diesem Fall durch den späteren Sägeschnitt in zwei Anschlußpads getrennt wird, bildet wiederum den Anschluß an die Bauteile 2. Die Bearbeitung der Substratrückseite beginnt wiederum mit dem ganzflächigen Vordünnen des Substrates bis auf einen Rest 6. Die Rückseite ist nach diesem Schritt eben und damit für die nachfolgende Maskierung besonders gut geeignet (Fig.6B). In der Abbildung sind am Beispiel außenseitig angeordneter Anschlußpfosten nur die wichtigsten Zwischenergebnisse dargestellt. Über eine Metallmaske 7a wird an den Positionen der auf der Vorderseite vordefinierten Substratpfosten die Pfostenfläche festgelegt. Zudem wird mit dieser Maske auch die Struktur der Pfostenunterseite vorgegeben, die für eine bessere Haftung auf der Leiterplatte sorgt. Mit einer zweiten Maske 13, wird die gesamte Unterseite bis auf den Substratbereich zwischen den benachbarten Pfosten abgedeckt (Fig.6C). Anschließend wird mit einer Ätzung das Substratmaterial zwischen den Pfosten so weit abgetragen, daß nach Entfernen der Maske 13 das noch verbleibende Substratmaterial im Bereich 14 zwischen den Pfosten, das Substratmaterial im Bereich 15 unter den Bauteilen und das Material in den zur Strukturierung der Pfostenunterseite vorgesehenen Bereichen 16 herausgeätzt wird (Fig.6E). Damit entsteht eine etwas erhabene Pfostenstruktur, die durch einen weiteren Maskenschritt mit einer Metallisierung versehen und damit zur Leiterbahn der Vorderseite elektrisch angeschlossen wird. Durch Zersägen an den Schnittflächen zwischen den Pfosten werden die nun gehäusten Bauteile vereinzelt. Diese können mit den üblichen Verfahrenschritten mit Hilfe von Lot auf die Leiterbahnen einer Leiterplatine gebondet werden. Aus der Abbildung ist zu ersehen, daß durch die steilen Pfostenflanken, die durch das anisotrope Ätzen ausgebildet werden, auch ein minimaler Abstand des Pfostens zum Bauteil immer noch die erforderte elektrische Isolation gewährleistet ist. Ferner bietet eine durch den Ätzprozeß ausgebildete Zinnenstruktur auf der Pfostenunterseite eine verbesserte Haftung des gehäusten Bauteils auf der Leiterbahn.

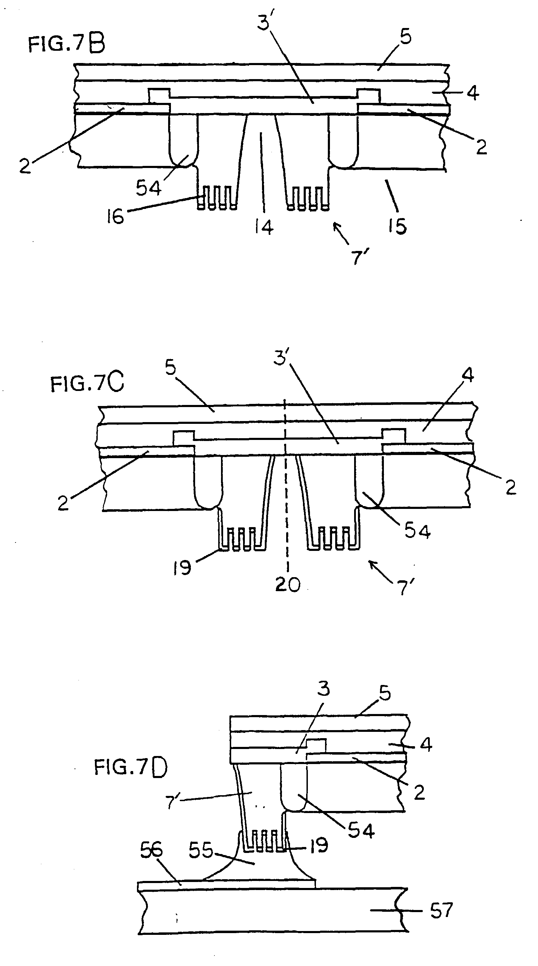

In einem weiteren Beispiel 5 wird der Verfahrensablauf gemäß dem vierten Beispiel in der Prozeßfolge laut Figur 7A bis C variiert. Die Prozeßfolge wird durch einen weiteren Maskenschritt ergänzt, wobei nach dem Aufbringen der ersten Metallmaske 7a, die gesamte Pfostenfläche mit einer weiteren Metällmaske 18, beispielsweise Chrom, abgedeckt wird und zuletzt wiederum eine Lackmaske 13 eine dritte Maskenebene bildet (Fig.7A). Auf diese Weise läßt sich durch einen dreistufigen Ätzprozeß die Tiefe der Struktur auf der Pfostenunterseite gezielt variieren (Fig.7B). Damit entsteht die Möglichkeit, die Geometrie der Pfostenunterseite so zu gestalten, daß sie auf die nachfolgenden Prozeßschritte beim Bonden der gehäusten Bauteile auf Leiterbahnen angepaßt werden können. Beispielsweise lassen sich durch ein vorgegebenes Lotmaterial und die Lotmenge in Verbindung mit der Materialauswahl bei der Metallisierung der Pfosten die Fließvorgänge des Lotes am Pfosten über das gegenseitige Benetzungsverhalten gezielt steuern. Wiederum werden durch einen weiteren Maskenschritt die Pfosten mit einer Metallisierung 19 versehen und damit zur Leiterbahn der Vorderseite elektrisch angeschlossen werden. Durch Zersägen an den Schnittflächen 20 zwischen den Pfosten werden die nun gehäusten Bauteile vereinzelt (Fig.7C). In Fig.7D ist ein Bauteil dargestellt, das mit Hilfe eines Lotmaterials 55 auf die Leiterbahn 56 einer Leiterplatte 57 kontaktiert wurde.

Die Erfindung ist nicht auf die angegebenen Ausfühungsbeispiele beschränkt, so daß es zur Herstellung der Gehäuse auch andere Halbleitermaterialien, Vergußmassen und Metallisierungen verwendet werden.

Beim Layout einer Schaltung können im Hinblick auf die vorgeschlagene Verpackungstechnologie die Anschlußpfosten an jeder Stelle des Wafers vorgesehen werden, solange durch die Trennspalte keine aktiven Struturen innerhalb des Chips zerstört werden. Für die Schaltung ergeben sich so bei geschickter Anordnung kürzere Leiterbahnen auf dem Chip, wobei ein Herausführen auf die Peripherie nicht mehr notwendig ist. Auch eine Umverdrahtung auf der Chiprückseite ist, wie bei anderen CSP-Verfahren üblich, nicht mehr nötig. Dadurch ergeben sich optimale Bedingungen für den Einsatz bei höchsten Frequenzen. Die Größe der Pfosten ist für die elektrische Funktion nicht entscheidend. Die minimale Größe wird durch die angewandte Ätztechnik bestimmt. Typische Anschlüßpfostenabmessungen sind 20x20µm und Trennspalte mit 30µm Breite, bei einer Tiefe von 100um. Für die Nutzung der Anschlußpfosten als Landefläche für Bumps reicht eine Fläche von 5x5µm aus.

## Patentansprüche

1. Gehäuse für elektrische Bauteile, bei denen mit einer leitenden Schicht versehene Anschlußpfosten, bestehend aus Substratmaterial, das Bauteil elektrisch von der Oberseite zur Unterseite angeschlossen ist, dadurch gekennzeichnet, daß Anschlußpfosten (7) als Träger für Leiterbahnen an geeigneter, jedoch beliebiger Position innerhalb oder innerhalb und außerhalb der von den Bauteilen (2) beanspruchten Fläche angeordnet sind.

2. Gehäuse für elektrische Bauteile nach Anspruch 1, dadurch gekennzeichnet, daß die Anschlußpfosten (7) gegenüber dem Substrat (1) elektrisch isoliert sind.

3. Gehäuse für elektrische Bauteile nach Anspruch 1 oder 2, dadurch gekennzeichnet, daß die Struktur der Anschlußpfosten (7) quader- oder tonnenförmig ausgebildet ist.

4. Gehäuse für elektrische Bauteile nach einem der Ansprüche 1, 2 oder 3, dadurch gekennzeichnet, daß die Anschlußpfosten (7) direkt auf einer Leiterplatte befestigt sind.

5. Gehäuse für elektrische Bauteile nach Anspruch 4, dadurch gekennzeichnet, daß Anschlußpfosten (7) an der Kontaktfläche zur Leiterplatte eine definierte Struktur zur besseren Haftung aufweisen.

6. Gehäuse für elektrische Bauteile nach einem der Ansprüche 1, 2 oder 3, dadurch gekennzeichnet, daß von den Anschlußpfosten (7) rückseitig Leiterbahnen zur Umverdrahtung angebracht sind.

7. Gehäuse für elektrische Bauteile nach einem der vorhergehenden Ansprüche, dadurch gekennzeichnet, daß die leitende Schicht (8) der Anschlußpfosten (7) eine Metallschicht oder eine ionenimplantierte Pfostenoberfläche ist.

8. Verfahren zur Herstellung von Gehäusen für elektrische Bauteile gemäß Anspruch 5, dadurch gekennzeichnet, daß
- Substrat- (1) und Chipoberfläche (2) mit einer elektrisch isolierenden Deckschicht mit Kontaktlöchern für elektrischen Anschlüsse versehen wird,
- Anschlußpads (3) an den Chiprand oder an die zur Durchführung des Anschlusses vorgesehene Stelle innerhalb des Chips (2) gelegt werden,
- Substrat (1) und Chipoberfläche (2) mit einer Abdeckung fest verbunden wird,
- das Substrat auf der Rückseite bis auf einen Rest (6) gedünnt wird
- Anschlußpfosten (7) im Substratmaterial, zum übrigen Substrat (1) isoliert, und der Ritzrahmen zur späteren Vereinzelung der Chips (2) bis auf die Anschlußpads (3) der Vorderseite geätzt werden,
- die Anschlußpfosten (7) metallisiert werden,
- daß die Fertigstellung der Anschlußpfosten, einschließlich der Struktur zur besseren Haftung, von der Rückseite durch einen mehrstufigen Ätzprozeß vorgenommen wird, bei dem sich steile Flanken an den Anschlußpfosten ausbilden, und
- daß der mehrstufige Ätzprozeß zur Fertigstellung der Pfosten mit Maskierungsschritten über mehrere Lagen auf der planaren Substratrückseite durchgeführt wird.

9. Verfahren zur Herstellung von Gehäusen für elektrische Bauteile gemäß Anspruch 6, dadurch gekennzeichnet, daß
- Substrat- (1) und Chipoberfläche (2) mit einer elektrisch isolierenden Deckschicht mit Kontaktlöchern für elektrischen Anschlüsse versehen wird,
- Anschlußpads (3) an den Chiprand oder an die zur Druchführung des Anschlusses vorgesehene Stelle innerhalb des Chips (2) gelegt werden,
- Substrat (1) und Chipoberfläche (2) mit einer Abdeckung fest verbunden wird,
- das Substrat auf der Rückseite bis auf einen Rest (6) gedünnt wird
- Anschlußpfosten (7) im Substratmaterial, zum übrigen Substrat (1) isoliert, und der Ritzrahmen zur späteren Vereinzelung der Chips (2) bis auf die Anschlußpads (3) der Vorderseite geätzt werden,
- die Anschlußpfosten (7) metallisiert werden,
- die gesamte Rückseite mit einer Vergußmasse (9) abgedeckt wird,
- an den Stellen, an denen sich die Anschlußpfosten (7) befinden, für eine Anschlußmetallisierung die Vergußmasse (9) auf der Rückseite abgeätzt wird und,
- der elektrische Kontakt (8) aufgebracht wird.

10. Verfahren nach Anspruch 8 oder 9, dadurch gekennzeichnet, daß als Abdeckung Substratmaterial (5), Silicium, Glas, Metall oder Keramik verwendet wird.

11. Verfahren nach Anspruch 8 oder 9, dadurch gekennzeichnet, daß die Chipoberseite bevorzugt mit einem gut wärmeleitenden Material abgedeckt wird.

12. Verfahren nach Anspruch 8 oder 9, dadurch gekennzeichnet, daß die Verbindung Chip-Abdeckung (5) mit einem Kleber(4) verbunden wird.

13. Verfahren nach Anspruch 8 oder 9, dadurch gekennzeichnet, daß die Chiprückseite mechanisch oder chemisch bis auf eine Restdicke von 75 bis 200µm gedünnt wird.

14. Verfahren nach Anspruch 8 oder 9, dadurch gekennzeichnet, daß die Anschlußpfosten mittels einem Hochraten-Plasmaätzprozeß anisotrop strukturiert werden.

15. Verfahren nach Anspruch 8 oder 9, dadurch gekennzeichnet, daß der Ritzrahmen für die Vereinzelung der Chips gleichzeitig mit den Anschlußpfosten mittels des Hochraten-Plasmaätzprozesses struktriert werden.

16. Verfahren nach Anspruch 8 oder 9, dadurch gekennzeichnet, daß die Metallisierung (8) der Anschlußpfosten mittels Sputtertechnik und anschließender Galvanisierung durchgeführt wird.

17. Verfahren nach Anspruch 9, dadurch gekennzeichnet, daß als Vergußmasse (9) Epoxy oder PMMA verwendet wird.

18. Verfahren nach Anspruch 9 und 17, dadurch gekennzeichnet, daß die Vergußmasse (9) so zurückgeätzt wird, daß die Anschlußpfosten (7) heraustreten.

19. Verfahren nach Anspruch 18, dadurch gekennzeichnet, daß der elektrische Kontakt mittels Umverdrahtung auf der Rückseite und/oder der BGA Technik aufgebracht wird.
